# EUROPEAN PATENT SPECIFICATION

(11) **EP 0 082 616 B1**
(45) Date of publication and mention of the grant of the patent: **10.03.1993**
(21) Application number: 82306376.3
(22) Date of filing: 01.12.1982
(51) Int. Cl.: H01L 27/14, H01L 29/78

(54) **Electric signal compressing apparatus**
Kompressionsschaltung für elektrische Signal
Dispositif de compression de signaux électriques

(30) Priority: 18.12.1981 US 332061
(43) Date of publication of application: 29.06.1983
(73) Proprietor: HONEYWELL INC., Minneapolis Minnesota 55408 (US)
(72) Inventor: Dries, Michael F., Chanhassen Minnesota 55317 (US); Gurnee, Mark N., Framingham Massachusetts 01701 (US)
(74) Representative: Fox-Male, Nicholas Vincent Humbert

(56) References cited:
- US-A- 2 069 237
- US-A- 4 032 948
- US-A- 4 275 404
- INTERNATIONAL ELECTRON DEVICES MEETING, TECHNICAL DIGEST, 3rd-5th December 1979, Washington, D.C., pages 552-555, IEEE, New York, US; M.N. GURNEE: "Detector/CCD coupling for hybrid focal planes"
- INTERNATIONALE ELECTRON DEVICES MEETING, TECHNICAL DIGEST, December 1979, pages 563-566, IEEE, New York, US; J.P. RODE et al.: "InAsSb hybrid imager evaluation"
- THE RADIO & ELECTRONIC ENGINEER, vol. 50, no. 5, May 1980, pages 226-236, Institution of Electronic and Radio Engineers; D.R. LAMB et al.: "The applications of charge coupled devices to infra-red image sensing systems"
- RCA REVIEW, vol. 35, no. 1, March 1974, pages 3-24; W.F. KOSONOCKY et al.: "Control of blooming in charge-coupled imagers"

## Description

The present invention relates to apparatus for compressing an electric input signal, e.g. from an infrared device so as to accommodate a large dynamic range of the signal which is to be transferred to a receiving device such as a charge coupled device (CCD).

The application of infrared detectors to imaging is growing steadily. As advanced infrared systems are being developed, the requirement for greater sensitivity and resolution is desired for many applications. System performance parameters relating to these requirements always depend on the signal to noise ratio of the many individual detectors comprising the focal plane. The use of multielement focal planes of small closely packed detectors, made possible by the use of charge coupled devices, has helped reduce the noise in such systems, while allowing use of a large number of detectors, and, therefore, better satisfy the sensitivity and resolution requirements.

The coupling circuit between the detectors and the CCDs must transform the signal information from the detectors into charges in the CCD shift registers with minimum degradation of the signal- to-noise ratio of the system. The input circuit must tailor the signal so that the CCD charge capacity is not exceeded when the signal, including the background signal, varies over the system dynamic range. In addition, the CCD must be protected from excess charge from signals beyond the system dynamic range, because excess charge injected into the CCD from one detector input will mix with charge from other inputs, thereby causing so-called image blooming and loss of information.

The gain of such input circuits must be uniform so that every CCD channel has the desired maximum signal capability without saturating the CCD. Some focal plane applications require the capability of handling a very large dynamic range, and, therefore, a very large range of signal or input current to the CCDs. For example, in some applications, the background seen by the detector varies over a range of up to 10,000 to 1. In addition, the input circuit must handle this large range of inputs while maintaining a low noise figure. An ac detector/CCD coupling approach has previously been used in an attempt to handle this dynamic range, however, it has been found that this approach is strongly susceptible to CCD input nonuniformities and CCD input low frequency noise. Further, such approach has no radiometric capability. A technique for handling moderate dynamic range, sometimes referred to as the Charge Equilibrium (CE) circuit, provides charge buffering by use of charge reduction or low gain. This technique reduces noise by use of a standard charge splitting circuit. For further information on these techniques, see the articles entitled "IR/CCD Hybrid Focal Planes" by R Broudy et al, published in The Proceedings of the Society of Photo-optical Instrumentation Engineers (SPiE), Volume 132, 1978, and "Multiplexed Intrinsic Detector Arrays With Signal Processing (MIDASP)" by M Gurnee et al, published in The Proceedings of the Society of Photo-optical Instrumentation Engineers (SPiE), Volume 217, 1980.

According to the present invention, there is provided a charge buffer circuits compressing an electrical charge input signal so as to accommodate a large dynamic range of the signal without loss of information represented by the signal, said circuit comprising first, second and third storage means (12, 14, 16) including first, second and third potential wells formed in a semiconductor substrate by voltage levels applied to bias each one of said storage means, said first potential well receiving the input signal, said first and second potential wells being adjacent to one another and having respective depths so as to allow signal current flow from said first potential well to said second potential well, said second and third potential wells being separated by a first gate (18) so as to selectively inhibit the signal current flow from the second potential well to the third potential well, and said third potential well being coupled to a receiving device,
said first gate being enabled in a first operation mode of the circuit to allow signal current flow through the first and second potential wells into the third potential well,and said first gate being disabled in a second operation mode of the circuit during signal charge transfer from said third potential well to said receiving device,
said circuit further comprising reset means (20, 22) coupled to the second potential well, said reset means resetting in a third operation mode of the circuit portions of the signal charge remaining in the first and second potential wells when the first gate is disabled,
said charge input-signal being compressed by maintaining the gain of the circuit so as to be dependent on the magnitude of the input signal
   - in that at a relatively low input signal level all of the signal charge is stored in the third potential well in the first operation mode and transferred to the receiving device in the second operation mode,
   - in that at a relatively medium input signal level the signal charge is stored in the second and third potential wells in the first operation mode so that only the portion of the signal charge stored in the third potential well is transferred to the receiving device in the second operation mode and the portion remaining in the second potential well is reset in the third operation mode, the gain of the circuit thus being substantially equal to the magnitude of the signal portion stored in the third potential well divided by the sum of the magnitudes of those signal portions stored in both the second and third potential wells, and
   - in that at a relatively high input signal level the signal charge is stored in the first, second and third potential wells in the first operation mode so that only the portion of the signal charge stored in the third potential well is transferred to the receiving device in the second operation mode and the portions remaining in the first and second potential wells are reset in the third operation mode, the gain of the circuit thus being proportional to the magnitude of that portion of the signal charge stored in the third potential well divided by the sum of the magnitudes of those signal portions stored in the first, second and third potential wells.

An embodiment of the invention will now be described by way of example only, with reference to the accompanying drawings, in which:-
Figure 1 illustrates diagrammatically the configuration of an input circuit signal compression apparatus according to the present invention;
Figure 2 illustrates the potentials applied to the various gates and the charge storage capacity of the various wells of the input circuit; and
Figure 3 illustrates the input compression characteristics of the input circuit.

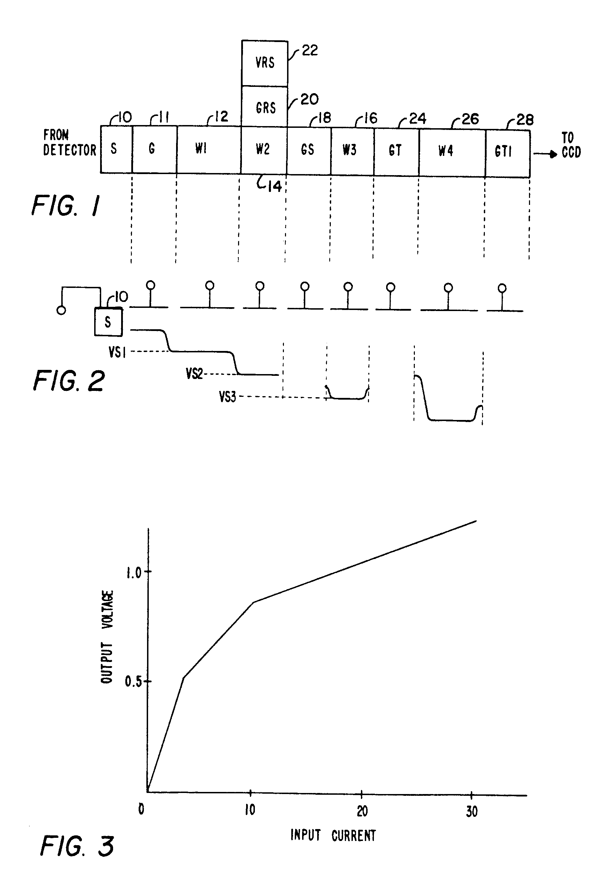

Referring to Figure 1, the detector apparatus includes a detector (not shown) which provides an input current to an input circuit via source 10 and gate 11. The input circuit includes three potential wells 12, 14 and 16. These wells are used to store minority charge carriers along the surface of a semiconductor just below insulated conductive regions which are biased with respect to the underlying crystal by an applied potential of a few volts (see Figure 2). The greater the potential applied, then the deeper the well is, and more charge can be stored in the deeper wells. The input circuit of the present apparatus utilizes, for example, three different potentials, VS1, VS2 and VS3. The potential VS1 is applied to well 12, VS2 applied to well 14, and VS3 applied to well 16. The potential VS1, is lower in magnitude than VS2, which in turn is lower than VS3. However, the potential VS3 could be lower than potential VS2.

Gate 11 is utilized to enable input current from the detector to flow into well 12 at a controlled rate determined by the system. In addition to gate 11, gate 18 is utilized to transfer charge into well 16 and isolate it there in accordance with system timing. Gate 20 is enabled at the appropriate time to reset, i.e., empty, the contents of wells 12 and 14 by use of a reset voltage 22. Gate 24 is enabled when the charge in well 16 is to be transferred to the charge coupled device CCD (not shown). This transfer to the CCD may be directly from gate 24 or may, in the alternative as shown, be made through well 26 and gate 28.

As described hereinafter, it will be seen that for low input currents, the input circuit of the present apparatus will have approximately unity gain, whereas, for mid-range and high input currents, the gain will be reduced. The input/output gain curve shown in Figure 3 illustrates a typical gain of the circuit of Figure 1. Three different gain slopes can be seen in Figure 3 for various input currents I. The output voltage Vₒ (to the CCD) is shown on the vertical axis. By use of different gains, the input current is "compressed" with the fixed gain or compression curve of Figure 3 before injection of the charge into the CCD, which may take the form of a well-known CCD shift register.

The operation of the input circuit, the configuration of which, and surface potentials for which, are shown in Figures 1 and 2, which Figures are aligned as indicated by the dotted lines, shall now be discussed.

At low background or signal level, the input current flows through wells 12 and 14 into well 16. Gate 11 is enabled continuously to allow such current flow, whereas gate 18 is enabled to allow current to flow into well 16. At low input current, all of the charge will be found stored in well 16 when gate 18 is disabled. At this time, the charge in well 16 will be transferred to the CCD (assuming that well 26 and gate 28 are not used). For large, but intermediate, input currents, well 16 will be filled above the level of potential VS2 such that charge is stored in both wells 16 and 14. Gate 18 is then disabled and the charge in well 16 is transferred to the CCD. The charge in well 14 is removed by resetting well 14 by the use of potential 22 when gate 20 is enabled. The incremental gain under these intermediate input conditions is given by the capacitance of well 16 divided by the sum of the capacitance of wells 14 and 16, or gain equals W3/(W3 + W2).

At high background and/or signal conditions, wells 16 and 14 are filled above potential VS2 and, therefore, charge is stored in the combination of wells 16, 14 and 12. When gate 18 is disabled, the charge stored in well 16 is transferred to the CCD. Following such transfer, the charge stored in wells 12 and 14 is reset by use of gate 20 and potential 22. The incremental gain under these high input conditions is given by the capacitance of well 16 divided by the sum of the capacitance of wells 16, 14 and 12, or gain equals W3/(W1 + W2 + W3).

It can be seen that the relative potentials on each storage well and the number of wells can be optimized for a specific application. That is, there may be more than three wells for any particular application. Further, a single large well with a potential variation, i.e, a continuous storage depth variation, along it can be formed, for example, by use of a resistive drop in a polysilicon gate, thereby providing a smooth compression characteristic.

It can also be seen that a so-called accumulator well 26 may be used. The accumulative well 26, coupled between gate 24 and gate 28, provides additional storage between the detector and the CCD. Accumulator well 26 is deeper than the other wells and may be used to collect and accumulate the charge received from well 16 for several input sample periods until such time as gate 28 is enabled to transfer the total charge in well 26 to the CCD. The accumulator well is utilized where unusually high input currents are encountered, thereby enabling the operation of wells 12, 14 and 16, as hereinbefore described, without encountering an overload condition which may cause a loss of information.

## Claims

1. Charge buffer circuit compressing an electrical charge input signal so as to accommodate a large dynamic range of the signal without loss of information represented by the signal,
said circuit comprising first, second and third storage means (12, 14, 16) including first, second and third potential wells formed in a semiconductor substrate by voltage levels applied to bias each one of said storage means, said first potential well receiving the input signal, said first and second potential wells being adjacent to one another and having respective depths so as to allow signal current flow from said first potential well to said second potential well, said second and third potential wells being separated by a first gate (18) so as to selectively inhibit the signal current flow from the second potential well to the third potential well, and said third potential well being coupled to a receiving device,
said first gate being enabled in a first operation mode of the circuit to allow signal current flow through the first and second potential wells into the third potential well,and said first gate being disabled in a second operation mode of the circuit during signal charge transfer from said third potential well to said receiving device,
said circuit further comprising reset means (20, 22) coupled to the second potential well, said reset means resetting in a third operation mode of the circuit portions of the signal charge remaining in the first and second potential wells when the first gate is disabled,
said charge input signal being compressed by maintaining the gain of the circuit so as to be dependent on the magnitude of the input signal
- in that at a relatively low input signal level all of the signal charge is stored in the third potential well in the first operation mode and transferred to the receiving device in the second operation mode,
- in that at a relatively medium input signal level the signal charge is stored in the second and third potential wells in the first operation mode so that only the portion of the signal charge stored in the third potential well is transferred to the receiving device in the second operation mode and the portion remaining in the second potential well is reset in the third operation mode, the gain of the circuit thus being substantially equal to the magnitude of the signal portion stored in the third potential well divided by the sum of the magnitudes of those signal portions stored in both the second and third potential wells, and
- in that at a relatively high input signal level the signal charge is stored in the first, second and third potential wells in the first operation mode so that only the portion of the signal charge stored in the third potential well is transferred to the receiving device in the second operation mode and the portions remaining in the first and second potential wells are reset in the third operation mode, the gain of the circuit thus being proportional to the magnitude of that portion of the signal charge stored in the third potential well divided by the sum of the magnitudes of those signal portions stored in the first, second and third potential wells.

2. Circuit according to Claim 1, characterised in that said reset means (20, 22) includes a second gate (20) coupled to a signal drain means (22).

3. Circuit according to Claim 1 or 2 characterised in that the input signal is received from an infrared detector and the receiving device is a charge coupled device.

4. Circuit according to any preceding Claim, characterised by including an accumulator storage means (26) successively accumulating a predetermined number of portions of the input signal transferred from the third storage means (16) prior to receipt thereof by the receiving device.

5. Circuit according to Claim 4 characterised in that the storage capacity of the accumulator storage means (26) is greater that the storage capacity of the third storage means (16).

6. Circuit according to any preceding Claim, characterised in that the storage capacity of the third storage means (16) is less than the storage capacity of the second storage means (14).

7. Circuit according to any preceding Claim characterised in that the first, second and third storage means (12, 14, 16) are, except for the first mentioned gate 18, contiguous with each other to collectively form one storage means having a continuous storage depth variation so that the magnitude of the signal capable of being stored increases continuously in and through each of the storage means.

## Patentansprüche

1. Ladungspufferschaltung zur Kompression eines elektrischen Ladungseingangssignals zwecks Verarbeitung eines großen Dynamikbereichs des Signals ohne Verlust an durch das Signal wiedergegebener Information;
wobei die Schaltung erste, zweite und dritte Speichereinrichtungen (12, 14, 16) mit ersten, zweiten und dritten Potentialmulden enthält, die in einem Halbleitersubstrat durch Spannungspegel gebildet werden, um jede der Speichereinrichtungen vorzuspannen, wobei die erste Potentialmulde das Eingangssignal empfängt, die ersten und zweiten Potentialmulden nebeneinander angeordnet sind und entsprechende Tiefen haben, damit Signalstrom von der ersten Potentialmulde in die zweite Potentialmulde fließen kann, die zweite und dritte Potentialmulde durch ein erstes Gatter (18) voneinander getrennt sind, um selektiv den Signalstromfluß von der zweiten Potentialmulde in die dritte Potentialmulde zu sperren, und wobei die dritte Potentialmulde an eine Empfangseinrichtung angeschlossen ist;
wobei das erste Gatter in einem ersten Betriebsmodus der Schaltung durchgeschaltet wird, um Signalstromfluß durch die ersten und zweiten Potentialmulden in die dritte Potentialmulde zu ermöglichen, und das erste Gatter in einem zweiten Betriebsmodus der Schaltung während der Signalladungsübertragung aus der dritten Potentialmulde zur Empfangseinrichtung gesperrt wird;
wobei die Schaltung ferner an die zweite Potentialmulde angeschlossene Rückstellmittel (20, 22) umfaßt die während eines dritten Betriebsmodus der Schaltung Teile der in der ersten und zweiten Potentialmulde verbleibenden Teile der Signalmulde zurücksetzen, wenn das erste Gatter gesperrt ist;
wobei das Ladungseingangssignal durch Aufrechterhalten des Verstärkungsgrades der Schaltung komprimiert wird, indem der Verstärkungsgrad von der Amplitude des Eingangssignals abhängig gemacht ist;
in dem bei einem relativ niedrigen Eingangssignalpegel die gesamte Signalladung während eines ersten Betriebsmodus in der dritten Potentialmulde gespeichert wird und in einem zweiten Betriebsmodus an die Empfangseinrichtung übertragen wird;
in dem bei mittleren Eingangssignalpegeln während des ersten Betriebsmodus die Signalladung in der zweiten und dritten Potentialmulde gespeichert wird, so daß nur der in der dritten Potentialmulde gespeicherte Teil der Signalladung während des zweiten Betriebsmodus an die Empfangseinrichtung übertragen wird und der in der zweiten Potentialmulde verbleibende Anteil während des dritten Betriebsmodus zurückgesetzt wird, wobei der Verstärkungsgrad der Schaltung praktisch gleich der Amplitude des in der dritten Potentialmulde gespeicherten Signalanteils ist, dividiert durch die Summe der Amplituden jener Signalanteile, die Zusammen in der zweiten und dritten Potentialmulde gespeichert sind; und
in dem bei relativ hohen Eingangssignalpegeln während des ersten Betriebsmodus die Signalladung in den ersten, zweiten und dritten Potentialmulden gespeichert wird, so daß nur der in der dritten Potentialmulde gespeicherte Teil der Signalladung während des zweiten Betriebsmodus an die Empfangseinrichtung übertragen wird, während die in den ersten und zweiten Potentialmulden bleibenden Ladungen während des dritten Betriebsmodus zurückgesetzt werden, wobei der Verstärkungsgrad der Schaltung somit der Amplitude jenes in der dritten Potentialmulde gespeicherten Anteils der Signalladung dividiert durch die Summe der Amplituden der in den ersten, zweiten und dritten Potentialmulden gespeicherten Signalanteile proportional ist.

2. Schaltungsanordnung nach Anspruch 1, dadurch gekennzeichnet, daß die Rücksetzeinrichtung (20, 22) ein an eine Signalsenke (22) angeschlossenes zweites Gatter (20) umfaßt.

3. Schaltungsanordnung nach Anspruch 1 oder 2, dadurch gekennzeichnet, daß das Eingangssignal von einem Infrarotdetektor geliefert wird und die Empfangseinrichtung ein ladungsgesteuertes Bauelement ist.

4. Schaltungsanordnung nach einem der vorangehenden Ansprüche, gekennzeichnet durch Verwendung eines Akkumulatorspeichers (26), der nacheinander eine vorgegebene Anzahl von Anteilen des von der dritten Speichereinrichtung (16) übertragenen Eingangssignals akkumuliert, ehe es von der Empfangseinrichtung aufgenommen wird.

5. Schaltungsanordnung nach Anspruch 4, dadurch gekennzeichnet, daß die Speicherkapazität des Akkumulatorspeichers (26) größer ist als die Speicherkapazität der dritten Speichereinrichtung (16).

6. Schaltungsanordnung nach einem der vorangehenden Ansprüche, dadurch gekennzeichnet, daß die Speicherkapazität der dritten Speichereinrichtung (16) kleiner ist als die Speicherkapazität der zweiten Speichereinrichtung (14).

7. Schaltungsanordnung nach einem der vorangehenden Ansprüche, dadurch gekennzeichnet, daß die erste, zweite und dritte Speichereinrichtung (12, 14, 16) mit Ausnahme des ersten Gatters (18) fortlaufend aneinandergereiht sind, um zusammen eine Speichereinrichtung mit gleichförmiger Speichertiefenänderung zu bilden, so daß die Amplitude des speicherbaren Signals innerhalb und durch die einzelnen Speichereinrichtungen kontinuierlich zunimmt.

## Revendications

1. Circuit de tampon de charge comprimant un signal d'entrée de charge électrique de façon à s'adapter à une large plage dynamique du signal sans perte d'information représentée par le signal,
ledit circuit comprenant un premier, un deuxième et un troisième moyens de mémorisation (12, 14, 16) comportant un premier, un deuxième et un troisième puits de potentiel formés dans un substrat semi-conducteur par des niveaux de tensions appliquées afin de polariser chacun desdits moyens de mémorisation, ledit premier puits de potentiel recevant le signal d'entrée, lesdits premier et deuxième puits de potentiel étant adjacents entre eux et leur profondeur respective étant apte à permettre un passage du courant du signal depuis ledit premier puits de potentiel vers ledit deuxième puits de potentiel, lesdits deuxième et troisième puits de potentiel étant séparés par une première porte (18) de façon à inhiber sélectivement le passage du courant du signal depuis le deuxième puits de potentiel vers le troisième puits de potentiel, et le troisième puits de potentiel étant couplé à un dispositif récepteur,
ladite première porte étant validée dans une premier mode de fonctionnement du circuit pour permettre un passage du courant du signal traversant le premier et le deuxième puits de potentiel vers le troisième puits de potentiel, et ladite première porte étant invalidée dans un deuxième mode de fonctionnement du circuit pendant un transfert de charge du signal depuis ledit troisième puits de potentiel vers ledit dispositif récepteur,
ledit circuit comprenant en outre des moyens de restauration (20, 22) couplés au deuxième puits de potentiel, lesdits moyens de restauration restaurant, dans un troisième mode de fonctionnement du circuit, des parties de la charge de signal restant dans le premier et le deuxième puits de potentiel lorsque la première porte est invalidée,
ledit signal d'entrée de charge étant comprimé en maintenant le gain du circuit de façon à dépendre de l'amplitude du signal d'entrée,
- en ce que, à un niveau de signal d'entrée relativement bas, toute la charge de signal est mémorisée dans le troisième puits de potentiel dans le premier mode de fonctionnement et est transférée vers le dispositif récepteur dans le deuxième mode de fonctionnement,
- en ce que, à un niveau de signal d'entrée relativement moyen, la charge de signal est mémorisée dans le deuxième et le troisième puits de potentiel dans le premier mode de fonctionnement de sorte que seule la partie de la charge de signal mémorisée dans le troisième puits de potentiel est transférée au dispositif récepteur dans le deuxième mode de fonctionnement et la partie restant dans le deuxième puits de potentiel est restaurée dans le troisième mode de fonctionnement, le gain du circuit étant ainsi sensiblement égal à l'amplitude de la partie de signal mémorisée dans le troisième puits de potentiel divisée par la somme des amplitudes des parties de signal mémorisées tant dans le deuxième que dans le troisième puits de potentiel , et
- en ce que, à un niveau de signal d'entrée relativement haut, la charge de signal est mémorisée dans le premier, le deuxième et le troisième puits de potentiel dans le premier mode d'opération de sorte que seule la partie de la charge de signal mémorisée dans le troisième puits de potentiel est transférée au dispositif récepteur dans le deuxième mode de fonctionnement et que les parties restant dans le premier et le deuxième puits de potentiel sont restaurées dans le troisième mode de fonctionnement, le gain du circuit étant ainsi proportionnel à l'amplitude de la partie de la charge de signal mémorisée dans le troisième puits de potentiel divisée par la somme des amplitudes des parties de signal mémorisées dans le premier, le deuxième et le troisième puits de potentiel .

2. Circuit selon la revendication 1, caractérisé en ce que lesdits moyens de restauration (20, 22) comportent une deuxième porte (20) couplée à un moyen (22) de drain de signal.

3. Circuit selon la revendication 1 ou 2 caractérisé en ce que le signal d'entrée est reçu depuis un détecteur infrarouge et le dispositif récepteur est un dispositif à transfert de charge.

4. Circuit selon une revendication précédente quelconque, caractérisé en ce qu'il comporte un moyen accumulateur de mémorisation (26) accumulant successivement un nombre prédéterminé de parties du signal d'entrée transférées depuis le troisième moyen de mémorisation (16) avant sa réception par le dispositif récepteur.

5. Circuit selon la revendication 4, caractérisé en ce que la capacité de mémorisation du moyen accumulateur de mémorisation (26) est supérieure à la capacité de mémorisation du troisième moyen de mémorisation (16).

6. Circuit selon une revendication précédente quelconque, caractérisé en ce que la capacité de mémorisation (16) du troisième moyen de mémorisation est inférieure à la capacité de mémorisation du deuxième moyen de mémorisation (14).

7. Circuit selon une revendication précédente quelconque, caractérisé en ce que le premier, le deuxième et le troisième moyens (12, 14, 16) sont, sauf pour la porte (18) mentionnée en premier lieu, contigus entre eux afin de former collectivement un moyen de mémorisation présentant une variation continue de profondeur de mémorisation de façon que l'amplitude du signal susceptible d'être mémorisé augmente de façon continue dans chaque moyen de mémorisation et à travers lui.
